# EUROPEAN PATENT APPLICATION

(11) **EP 1 921 670 A2**
(43) Date of publication of application: **14.05.2008**
(21) Application number: 07021716.1
(22) Date of filing: 08.11.2007
(51) Int. Cl.: H01L 21/60, H01L 23/31, H01L 21/48

(54) **Manufacturing method of semiconductor device**

(30) Priority: 08.11.2006 JP 2006303139
(71) Applicant: SHINKO ELECTRIC INDUSTRIES CO., LTD., Nagano-shi, Nagano 381-2287 (JP)
(72) Inventor: Machida, Yoshihiro, Nagano-shi Nagano 381-2287 (JP); Kobayashi, Toshio, Nagano-shi Nagano 381-2287 (JP)
(74) Representative: Zimmermann, Gerd Heinrich

(57) **Abstract**

A manufacturing method of a semiconductor device is featured by including: a step for forming a bump (104) on an electrode pad (103) by a bonding wire, the electrode pad being formed in an area corresponding to a semiconductor chip of a substrate (101A); a step in which a via hole (201C) is formed in a stacked layer-purpose substrate stacked on the substrate, a conductive layer has been formed on a first major plane of the stacked layer-purpose substrate; the via hole reaches from a second major plane of the stacked layer-purpose substrate to the conductive layer; and the via hole is embedded by conductive paste (202); a step for adhering the stacked layer-purpose substrate through an insulating layer (105) onto the substrate, and for joining the conductive layer (201A) to the bump (104) by the conductive paste (202); and a step for dividing the substrate in separated pieces.

## Description

The present invention is related to a manufacturing method of a semiconductor device and, in particular to a manufacturing method of a semiconductor device to which a chip size packaging with employment of bumps is applied.

Various types of packaging structures for semiconductor chips have been proposed. For instance, in connection with compactnesses of packagings, such a structure which is so-called as a "chip size packaging" has been proposed. In the "chip size packaging" structure, a re-wiring line (namely, wiring line for packaging) is formed on a passivation layer (protection layer) of a device formed plane of a semiconductor chip.

In the above-described chip size packaging, the below-mentioned methods have been proposed (refer to, for instance, patent document JP-A-9-64049): That is, for example, bumps are formed on electrode pads of a semiconductor chip by employing bonding wires, re-wiring lines which are connected to these bumps are formed so as to form packagings (semiconductor device).

However, in the method related to the above-described patent document JP-A-9-64049, in the case that the re-wiring line is formed which is connected to the bumps formed by the bondings, there is such a problem that leveling of the heights of the bumps is required.

For instance, the bumps formed by the boding wires are formed by employing, for instance, a bonding apparatus, and are formed by joining the bonding wires to the electrode pads, and by cutting the bonding wires after the joining operation in the continuous manner.

As a result, as to the bumps which are formed by the above-described bonding wires, there is a fluctuation in heights from the planes (electrode pads) where the bumps are formed. If this condition is kept, then the re-wiring lines to be connected to the bumps can be hardly formed. As a consequence, such a step is required by which predetermined weight is applied to these bumps so as to flatten these bumps.

The above-explained flattening operation of the bumps is usually carried out in a wafer level (before chip is diced in separated pieces). However, for instance, with respect to wafers whose diameters are 300 mm which constitute recent major wafer sizes, when a large number of the above-described bumps formed in such wafers are flattened, there is another problem that fluctuations in the heights of these bumps after being flattened are increased.

For example, if the fluctuations in the heights of these bumps are increased, then such a fluctuation may occur in the connection condition between the bumps and the re-wiring lines to be connected to these bumps. As a result, there is another problem that reliability of the semiconductor devices (packaging) is deteriorated.

Further, in the method related to the above-described patent document JP-A-9-64049, since the insulating layer is formed so as to cover the bumps, the polishing step for polishing the insulating layer in order to expose the bumps is required. Further, in order to form the re-wiring line after this polishing step, for example, when an electroless plating method is employed, such a process (so-called "desmear process") operation for roughing the surface of the insulating layer is required, so that the process operation for forming the plated layer becomes complex. As a consequence, this may cause the cost up aspect in the semiconductor device (packaging) manufacture.

Although the conductive layer may be formed by employing a sputtering method, a CVD (Chemical Vapor Deposition) method, and the like, these methods necessarily require an expensive film forming apparatus having a vacuum chamber. As a result, these methods may conduct higher cost of semiconductor device manufacturing methods, and cannot be practically employed.

As a consequence, the present invention has a unified object to provide such a novel and useful method for manufacturing a semiconductor device, which can solve the above-described problems.

A concrete object of the present invention is to provide a manufacturing method of a semiconductor device, capable of manufacturing a highly reliable semiconductor device in low cost.

In light of the above, manufacturing methods of a semiconductor device according to independent claims 1, 4 and 9 are provided.

Further advantages, features, aspects and details are evident from the dependent claims, the description and the drawings.

In order to the above-described problems, according to a first aspect of the present invention, there is provided with a manufacturing method of a semiconductor device, including:
a step for forming a bump on an electrode pad by a bonding wire, the electrode pad being formed in an area corresponding to a semiconductor chip of a substrate;
a step for forming a via hole in a stacked layer-purpose substrate stacked on the substrate, a conductive layer being formed on a first major plane of the stacked layer-purpose substrate, the via hole reaching from a second major plane of the stacked layer-purpose substrate to the conductive layer, and for embedding the via hole by conductive paste;
a step for adhering the stacked layer-purpose substrate through an insulating layer onto the substrate, and for joining the conductive layer to the bump by the conductive paste; and
a step for dividing the substrate in separated pieces, wherein
the bump penetrates the insulating layer.

Further, in order to the above-described problems, according to a second aspect of the present invention, there is provided with a manufacturing method of a semiconductor device, including:
a step for forming a bump on an electrode pad by a bonding wire, the electrode pad being formed in an area corresponding to a semiconductor chip of a substrate;
a step for forming a connection pattern made of conductive paste on a conductive layer which is stacked on the substrate;
a step for adhering the conductive layer through an insulating layer onto the substrate, and for joining the conductive layer to the bump by the connection pattern; and
a step for dividing the substrate in separated pieces, wherein
the bump penetrates the insulating layer.

Further, in order to the above-described problems, according to a third aspect of the present invention, there is provided with a manufacturing method of a semiconductor device, including:
a step for forming a bump on an electrode pad by a bonding wire, the electrode pad being formed in an area corresponding to a semiconductor chip of a substrate;
a step for contacting a tip portion of the bump to a layer made of conductive paste so as to transfer the conductive paste to the tip portion;
a step for adhering a conductive layer stacked on the substrate through an insulating layer onto the substrate, and for joining the conductive layer to the bump by the conductive paste; and
a step for dividing the substrate in separated pieces, wherein
the bump penetrates the insulating layer.

In accordance with the present invention, the manufacturing method of the semiconductor device can be provided by which the semiconductor device having higher reliability can be manufactured in low cost.

Embodiments are also directed to apparatuses manufactured by the disclosed methods and including apparatus parts corresponding to described method steps. Method steps may be performed by way of hardware components, firmware, software, a computer programmed by appropriate software, by any combination thereof or in any other manner.

The invention will be better understood by reference to the following description of embodiments taken in conjunction with the accompanying drawings, wherein:
Fig. 1A is a diagram (NO.1) for showing a manufacturing method of a semiconductor device according to an embodiment 1.
Fig. 1B is a diagram (NO.2) for indicating a manufacturing method of the semiconductor device according to the embodiment 1.
Fig. 1C is a diagram (NO.3) for representing a manufacturing method of the semiconductor device according to the embodiment 1.
Fig. 1D is a diagram (NO.4) for showing a manufacturing method of the semiconductor device according to the embodiment 1.
Fig. 1E is a diagram (NO.5) for indicating a manufacturing method of the semiconductor device according to the embodiment 1.
Fig. 1F is a diagram (NO.6) for representing a manufacturing method of the semiconductor device according to the embodiment 1.
Fig. 1G is a diagram (NO.7) according to a manufacturing method of the semiconductor device according to the embodiment 1.
Fig. 1H is a diagram (NO.8) according to a manufacturing method of the semiconductor device according to the embodiment 1.
Fig. 1I is a diagram (NO.9) according to a manufacturing method of the semiconductor device according to the embodiment 1.
Fig. 1J is a diagram (NO.10) according to a manufacturing method of the semiconductor device according to the embodiment 1.
Fig. 1K is a diagram (NO. 11) according to a manufacturing method of the semiconductor device according to the embodiment 1.
Fig. 2A is a diagram (NO.1) for showing a manufacturing method of a semiconductor device according to an embodiment 2.
Fig. 2B is a diagram (NO.2) for indicating a manufacturing method of the semiconductor device according to the embodiment 2.
Fig. 2C is a diagram (NO.3) for representing a manufacturing method of the semiconductor device according to the embodiment 2.
Fig. 3A is a diagram (N0.1) for showing a manufacturing method of a semiconductor device according to an embodiment 3.
Fig. 3B is a diagram (NO.2) for indicating a manufacturing method of the semiconductor device according to the embodiment 3.
Fig. 3C is a diagram (N0.3) for representing a manufacturing method of the semiconductor device according to the embodiment 3.
Fig. 3D is a diagram (NO.4) for showing a manufacturing method of the semiconductor device according to the embodiment 3.
Fig. 3E is a diagram (NO.5) for indicating a manufacturing method of the semiconductor device according to the embodiment 3.
Fig. 3F is a diagram (NO.6) for representing a manufacturing method of the semiconductor device according to the embodiment 3.
Fig. 4A is a diagram (N0.1) for showing a manufacturing method of a semiconductor device according to an embodiment 4.
Fig. 4B is a diagram (NO.2) for indicating a manufacturing method of the semiconductor device according to the embodiment 4.
Fig. 4C is a diagram (NO.3) for representing a manufacturing method of the semiconductor device according to the embodiment 4.
Fig. 5A is a diagram (NO.1) for showing a manufacturing method of a semiconductor device according to an embodiment 5.
Fig. 5B is a diagram (NO.2) for indicating a manufacturing method of the semiconductor device according to the embodiment 5.
Fig. 5C is a diagram (NO.3) for representing a manufacturing method of the semiconductor device according to the embodiment 5.
Fig. 6A is a diagram (NO.1) for showing a manufacturing method of a semiconductor device according to an embodiment 6.
Fig. 6B is a diagram (NO.2) for indicating a manufacturing method of the semiconductor device according to the embodiment 6.
Fig. 6C is a diagram (NO.3) for representing a manufacturing method of the semiconductor device according to the embodiment 6.
Fig. 6D is a diagram (NO.4) for showing a manufacturing method of the semiconductor device according to the embodiment 6.
Fig. 6E is a diagram (NO.5) for indicating a manufacturing method of the semiconductor device according to the embodiment 6.
Fig. 6F is a diagram (NO.6) for representing a manufacturing method of the semiconductor device according to the embodiment 6.
Fig. 6G is a diagram (NO.7) according to a manufacturing method of the semiconductor device according to the embodiment 6.
Fig. 6H is a diagram (NO.8) according to a manufacturing method of the semiconductor device according to the embodiment 6.
Fig. 7 is a modification of the manufacturing method of the semiconductor device according to the embodiment 6.
Fig. 8A is a diagram (N0.1) for showing a manufacturing method of a semiconductor device according to an embodiment 7.
Fig. 8B is a diagram (NO.2) for indicating a manufacturing method of the semiconductor device according to the embodiment 7.
Fig. 8C is a diagram (NO.3) for representing a manufacturing method of the semiconductor device according to the embodiment 7.
Fig. 8D is a diagram (NO.4) for showing a manufacturing method of the semiconductor device according to the embodiment 7.
Fig. 8E is a diagram (NO.5) for indicating a manufacturing method of the semiconductor device according to the embodiment 7.
Fig. 8F is a diagram (NO.6) for representing a manufacturing method of the semiconductor device according to the embodiment 7.
Fig. 8G is a diagram (NO.7) according to a manufacturing method of the semiconductor device according to the embodiment 7.
Fig. 8H is a diagram (NO.8) according to a manufacturing method of the semiconductor device according to the embodiment 7.
Fig. 9A is a diagram (N0.1) for showing a manufacturing method of a semiconductor device according to an embodiment 8.
Fig. 9B is a diagram (NO.2) for indicating a manufacturing method of the semiconductor device according to the embodiment 8.
Fig. 9C is a diagram (NO.3) for representing a manufacturing method of the semiconductor device according to the embodiment 8.
Fig. 9D is a diagram (NO.4) for showing a manufacturing method of the semiconductor device according to the embodiment 8.
Fig. 9E is a diagram (N0.5) for indicating a manufacturing method of the semiconductor device according to the embodiment 8.
Fig. 9F is a diagram (NO.6) for representing a manufacturing method of the semiconductor device according to the embodiment 8.
Fig. 9G is a diagram (NO.7) according to a manufacturing method of the semiconductor device according to the embodiment 8.
Fig. 10A is a diagram (N0.1) for showing a manufacturing method of a semiconductor device according to an embodiment 9.
Fig. 10B is a diagram (NO.2) for indicating a manufacturing method of the semiconductor device according to the embodiment 9.

The manufacturing method of the semiconductor device, according to the present invention, is featured by mainly comprising: 1) a first step for forming a bump by a bonding wire on an electrode pad formed on an area corresponding to a semiconductor chip of a substrate; 2) a second step for joining the bump to a conductive layer (corresponding to re-wiring line of semiconductor chip); and 3) a third step for dividing the substrate in separated pieces.

In other words, in the above-described manufacturing method, since the bumps are joined to the conductive layer corresponding to the re-wiring line of the semiconductor chip by employing conductive paste, reliability as to the electric connection between the bumps and the conductive layer can be hardly influenced by the fluctuation in the heights of the bumps (namely, projection portions of bumps) . As a result, while such bumps having a relatively large height fluctuation are employed which are formed by, for example, bonding wires, such a re-wiring line having superior connection reliability can be formed by an easy method.

For instance, the above-described second step may be arranged by comprising: 1) a step in which a via hole is formed in a stacked layer-purpose substrate stacked on the substrate, a conductive layer has been formed on a first major plane of the stacked layer-purpose substrate; the via hole reaches from a second major plane of the stacked layer-purpose substrate to the conductive layer; and the via hole is embedded by conductive paste; and also, 2) a step for adhering the stacked layer-purpose substrate through an insulating layer onto the substrate, and for joining the conductive layer to the bump by the conductive paste (first method).

In accordance with the first method, the conductive layer (re-wiring line) can be electrically connected to the bumps by the conductive paste for embedding the via hole in superior reliability. As previously explained, the reliability as to the electric connection between the bumps and the conductive layer can be hardly influenced by the fluctuation in the heights of the bumps.

Further, in accordance with the above manufacturing method, when the conductive layer (re-wiring line) is formed on the insulating layer, for instance, either the electroless plating method in conjunction with the desmear process or the film forming (sputtering process etc.) process in conjunction with the process performed in the vacuum chamber is no longer required. As a result, the manufacturing method of the semiconductor device can be simplified, and thus, there is such an effect that the manufacturing cost can be suppressed.

Alternatively, for instance, the above-explained second step may be arranged by comprising: 1) a step for forming a connection pattern made of conductive paste on a conductive layer which is stacked on the substrate; and also, 2) a step for adhering the conductive layer through an insulating layer onto the substrate, and for joining the conductive layer to the bump by the connection pattern (second method).

In accordance with the secondmethod, the conductive layer (re-wiring line) can be electrically connected to the bumps by the conductive paste formed on the conductive layer in superior reliability. As previously explained, the reliability as to the electric connection between the bumps and the conductive layer can be hardly influenced by the fluctuation in the heights of the bumps.

Further, in accordance with the above manufacturing method, when the conductive layer is formed on the insulating layer, for instance, either the electroless plating method in conjunction with the desmear process or the film forming process in conj unction with the process performed in the vacuum chamber is no longer required. As a result, the manufacturing method of the semiconductor device can be simplified, and thus, there is such an effect that the manufacturing cost can be suppressed.

Alternatively, for instance, the above-explained second step may be arranged by comprising: 1) a step for contacting a tip portion of the bump to a layer made of conductive paste so as to transfer the conductive paste to the tip portion; and also 2) a step for adhering a conductive layer which is stacked on the substrate through an insulating layer onto the substrate, and for joining the conductive layer to the bump by the conductive paste (third method).

Further, in accordance with the third method, the highly reliable semiconductor device can be manufactured in low cost.

Next, the above-described manufacturing method of the semiconductor device will be described based upon drawings in this order from the first method to the third method.

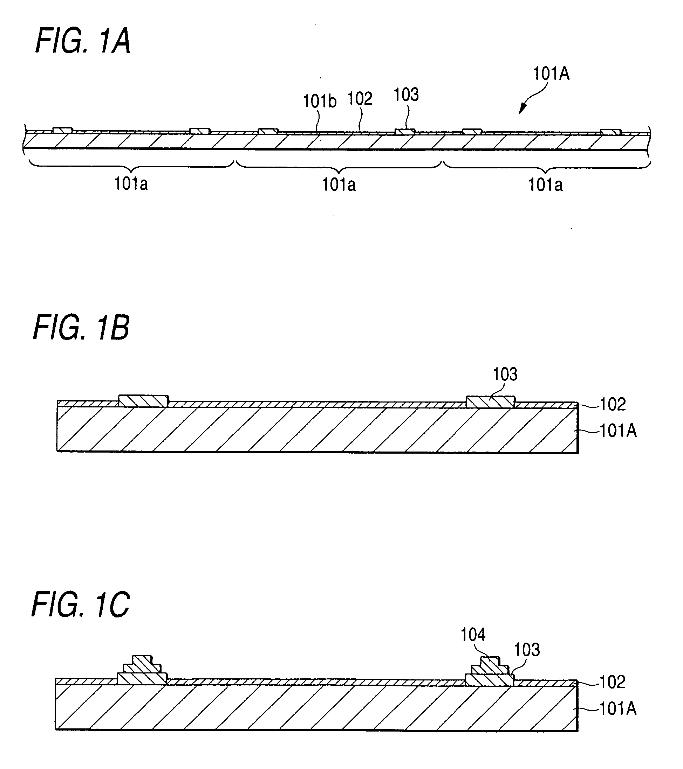

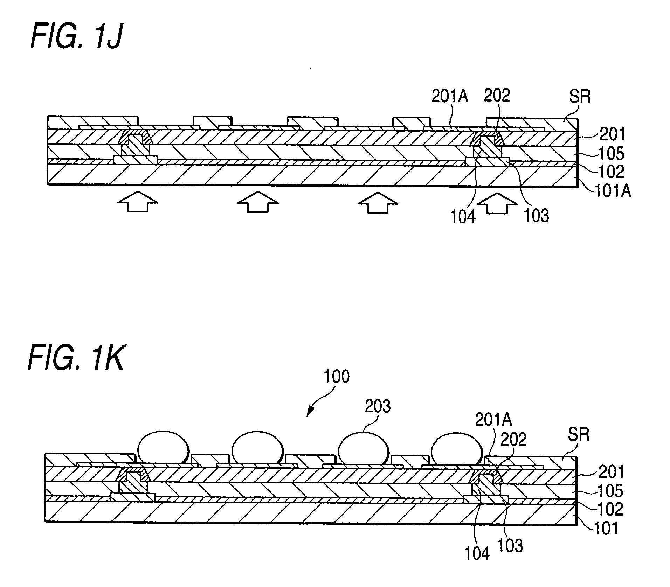

Firstly, a description is made of one example as to the previously explained first method based upon Fig. 1A to Fig. 1K in a sequential manner. It should be noted that the same reference numerals explained in the above descriptions will be employed for denoting the same structural elements in the below-mentioned descriptions (below-mentioned drawings), and explanations thereof will be sometimes omitted (similarly applied to below-mentioned embodiments).

Firstly, in a step shown in Fig. 1A, a substrate 101A having a plurality (for example, grid shaped) of areas 101a where devices have been formed is manufactured by employing a known method. The above-described area 101a is an area equivalent to one semiconductor chip. After a re-wiring line (conductive layer) has been formed in the below-explained step, the substrate 101A is cut by dicing, so that semiconductor devices (semiconductor chips) are formed in separated pieces on the area 101a.

Electrode pads 103 have been formed on a device forming plane 101b of the above-described area 101a, on which the devices have been formed. Further, a portion of the device forming plane 101b other than the electrode pads 103 has been protected by a protection layer (passivation layer) 102 made of, for example, SiN (Si₃N₄) .

Fig. 1B is a diagram for showing that one area 101a of the substrate 101A shown in Fig. 1A is enlarged. With respect to drawings subsequent to Fig. 1B, within the substrate 101A where a plurality of areas 101a have been formed, while one area 101a will be exemplified, a description will be made of a method for manufacturing a semiconductor device.

Next, in a step shown in Fig. 1C, an electrode pad 104 formed by a wire bonding made of Au is formed on the electrode pad 103 by employing, for example, a wire bonding apparatus. The wire bonding apparatus joins the bounding wire to the electrode pad 103, and cuts the bonding wire after being joined in a continuous manner so as to form a bump 104 having a projection portion.

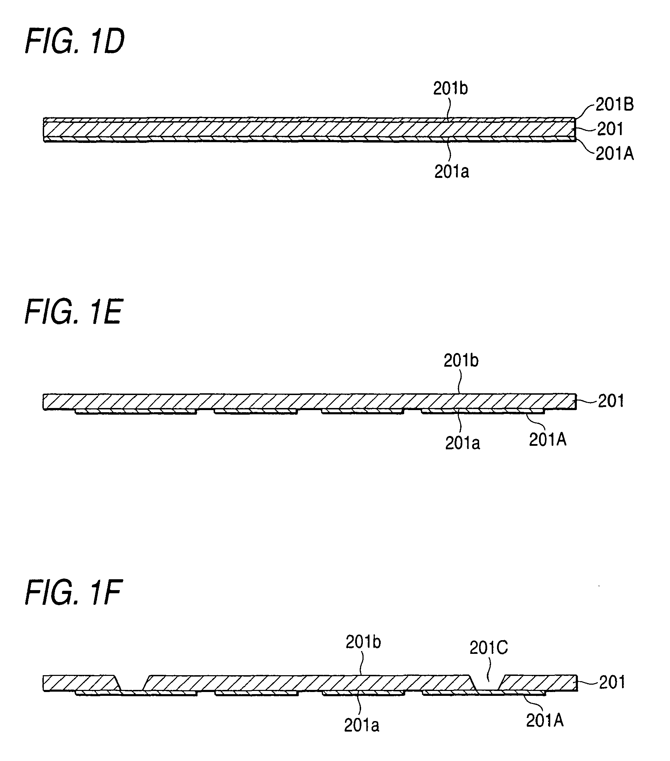

Next, in steps indicated in Fig. 1D to Fig. 1G, a re-wiring line is formed which is connected to the above-described substrate 101A (semiconductor chip).

Firstly, in the step shown in Fig. 1D, a stacked layer-purpose substrate (core substrate) 201 is prepared, the stacked layer-purpose substrate 201 is made of such a resin material as a prepreg material, and is equipped with Cu foil on both planes thereof. Conductive layers 201A and 201B made of Cu foil have been adhered onto a first major plane 201a and a second major plane 201b of the stacked layer-purpose substrate 201.

Next, in the step shown in Fig. 1E, the conductive layer (Cu foil) 201B of the second major plane 201b is removed by an etching process. Furthermore, the conductive layer (Cu foil) 201A of the first major plane 201a is patterned by performing a pattern etching process with employment of a mask pattern.

Next, in a step shown in Fig. 1F, a via hole 201C is formed by employing, for example, a laser, or the like, while the via hole 201C reaches the conductive layer 201A of the first major plane 201a from the side of the second major plane 201b of the stacked layer-purpose substrate 201, and penetrates through the stacked layer-purpose substrate 201. Further, after the via hole 201C has been formed, the stacked layer-purpose substrate 201 may be cleaned by using plasma, if necessary.

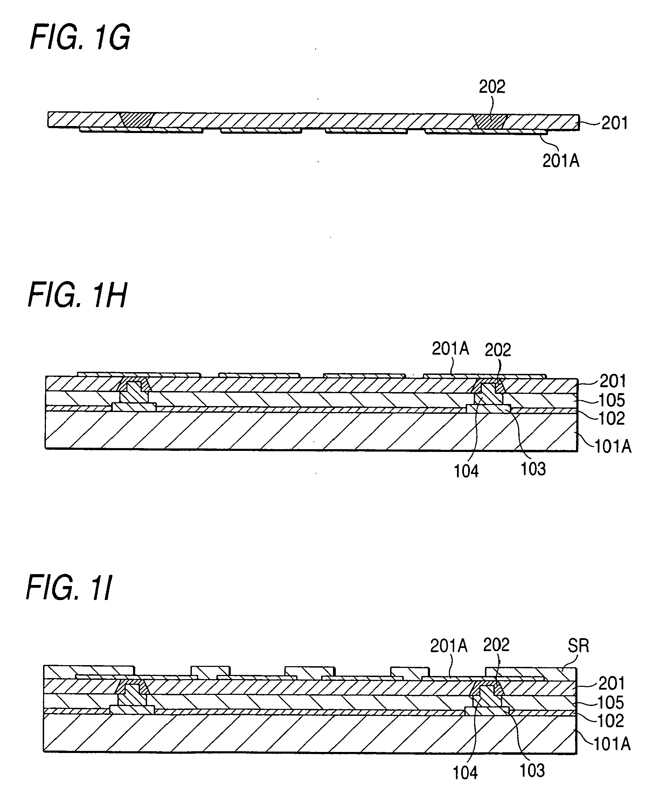

Next, in a step shown in Fig. 1G, the via hole 201C formed in the previous step of Fig. 1F is embedded by paste 202 having a conductive characteristic. A re-wiring line is manufactured in the above-described manner, which is to be stacked (connected) on the previously described substrate 101A.

Then, in a step shown in Fig. 1H, the stacked layer-purpose substrate 201 is adhered onto the substrate 101A through an insulating layer 105 made of, for example, a resin material of an epoxy series, and the conductive layer 201A is joined to the bump 104 by the conductive paste 202. In this case, since the insulating layer 105 penetrates through the bump 104, it is preferable to employ such a soft resin material called as, for example, "NCF" in the insulating layer 105. In the soft resin material, substantially no hardness adjusting material such as a filler has been added. Since the above-described soft resin material is employed, the bump 104 can be easily exposed from the insulating layer 105.

Further, the insulating layer 105 is not limited only to the above-described material, but may be alternatively formed by employing various sorts of insulating materials (resin materials). For example, a so-termed "build up resin (epoxy resin into which filler has been added)" which is usually used, or another resin material called as an "ACF" may be alternatively employed as the insulating layer 105.

Further, in the above-described case, any one of the following methods may be employed: In one method, the insulating layer 105 is firstly formed on the substrate 101A (protection layer 102) by a coating manner, or a laminating manner, and thereafter, the stacked layer-purpose substrate 201 is adhered thereto. In another method, the insulating layer 105 and the stacked layer-purpose substrate 201 are previously stacked with each other, and then, the stacked layer/substrate is adhered to the substrate 101A (protection film 102).

In this step, both the stacked layer-purpose substrate 201 and the insulating layer 105 are pressed and heated. In this step, the insulating layer 105 having a thermosetting characteristic is cured (hardened), and the conductive paste 202 is cured.

In this step, the conductive paste 202 is cured under such a condition that a tip portion (projection portion) of the bump 104 has been inserted in the conductive paste 202 embedded in the via hole. As a consequence, reliability as to the electric connection between the bump 104 and the conductive layer 201A can be hardly influenced by fluctuations in heights of the bumps 104. In other words, an allowable value as to the height fluctuations of the bumps 104 is increased in correspondence with a depth of the via hole 201C (namely, thickness of stacked layer-purpose substrate 201).

As a consequence, while the bumps 104 having the relatively large height fluctuations are employed which are formed by employing, for example, bonding wires, the re-wiring lines having the superior connection reliability can be manufactured by an easy method. Further, in the above-described method, a polishing step is not required which causes the projection portion of the bump 104 to be exposed from the insulating layer 105. Further, the above-described connection method for connecting the bump 104 with the conductive layer 201A may become easier than the conventional connection method such as a soldering method, and also has such a feature that the connecting reliability becomes high.

Further, in this step, the insulating layer 105 is cured (thermally hardened) by that the insulating layer 105 is pressed and heated in combination with the stacked layer-purpose substrate 201. As a result, adhesion between the insulating layer 105 and the stacked layer-purpose substrate 201 becomes superior.

Next, in a step shown in Fig. 11, a roughing process (so-called "desmear" process) is carried out with respect to the surface of the conductive layer 201A (Cu), if required, and thereafter, a solder resist layer (insulating layer) SR having opening portions is formed on the insulating layer 105. Portions of the conductive layer 201A are exposed from the opening portions of the solder resist layer SR.

Next, in a step represented in Fig. 1J, a rear plane of the substrate 101A is polished, if necessary, so as to make a predetermined thickness of the substrate 101A.

Next, in a step indicated in Fig. 1K, solder bumps 203 are formed on the conductive layers 201A which are exposed from the opening portions of the solder resist layer SR, if necessary. In addition, a dicing process of the substrate 101A is carried out in order to cut the substrate 101A in separated pieces, so that the separated substrate piece constitutes a semiconductor chip 101. Thus, a semiconductor device 100 in which the re-wiring line (conductive layer 201A) is connected to the semiconductor chip 101 can be manufactured.

As previously explained, in accordance with the above-described manufacturing method, while the reliability as to the electric connection between the bumps 104 and the conductive layer 201A can be hardly and is not adversely influenced by the height fluctuation of the bumps 104, such a semiconductor device that the connection reliability of the re-wiring line becomes superior can be manufactured by employing the bumps formed by the easily manufactured wire bondings.

Further, as described in the conventional semiconductor device manufacturing method, in such a case that a seed layer (power feeding layer) is formed by an electroless plating and thereafter a re-wiring line is formed by the electroless plating, for instance, a process for roughing (so-called "desmear process") a surface of an insulating layer is required in order to perform the electroless plating method. As a result, there is such a problem that the process operations become complex. Further, in the case that the power feeding layer is formed by a sputtering method, since an expensive film forming apparatus having a vacuum processing vessel is required, there is such a risk that manufacturing cost is increased.

On the other hand, in the manufacturing method according to this embodiment 1, the desmear process and the sputtering process executed in the vacuum chamber are no longer required, and therefore, there is such a feature that the re-wiring line can be readily formed by the simple method. As a consequence, in accordance with the above-described method, the method for manufacturing the semiconductor device can become simple, and the manufacturing cost can be suppressed.

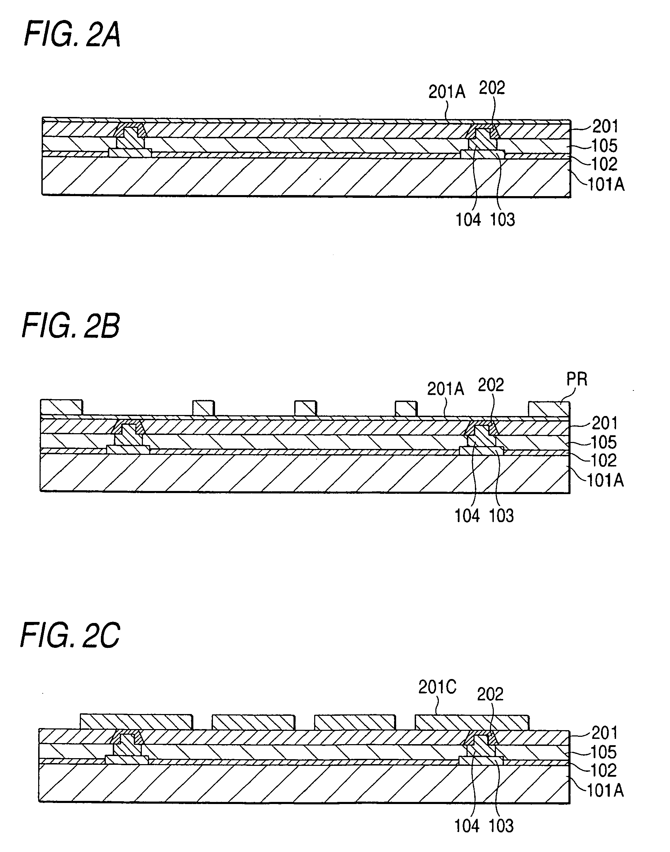

Alternatively, as will be discussed in the following description, the above-described re-wiring line may be formed by employing a semi-additive method. In this alternative case, for instance, in the above-described manufacturing method, the steps shown in Fig. 1A to Fig. 1H are firstly executed so as to form such a condition as indicated in Fig. 2A. It should be understood that in this alternative case, in the step of Fig. 1E, the patterning (etching) process operation of the conductive layer 201A is not carried out, but the conductive layer 201A is brought into such a condition that this conductive layer 201A has been continuously (in flat plane shape) formed.

Next, in a step shown in Fig. 2B, a mask pattern PR having an opening portion is formed on the above-described conductive layer 201A. The mask pattern PR can be formed by forming a resist layer by being coated, or by adhering a film, and also, by patterning the formed resist layer with employment of a photolithography method.

Next, in a step shown in Fig. 2C, a conductive layer (conductive pattern) 201C made of Cu is formed on the conductive layer 201A exposed from the opening portion of the mask pattern PR by such an electrolytic plating method that the conductive layer 201A is employed as a power feeding layer (seed layer). After the above-described pattern plating has been carried out, since the mask pattern PR is stripped and the mask pattern PR is furthermore stripped, an extra conductive layer 201A which is exposed is removed by an etching process, so that a similar structure to that of Fig. 1H can be manufactured. Subsequently, since steps similar to the above-described steps indicated in Fig. 11 to Fig. 1K are carried out, a semiconductor device can be manufactured.

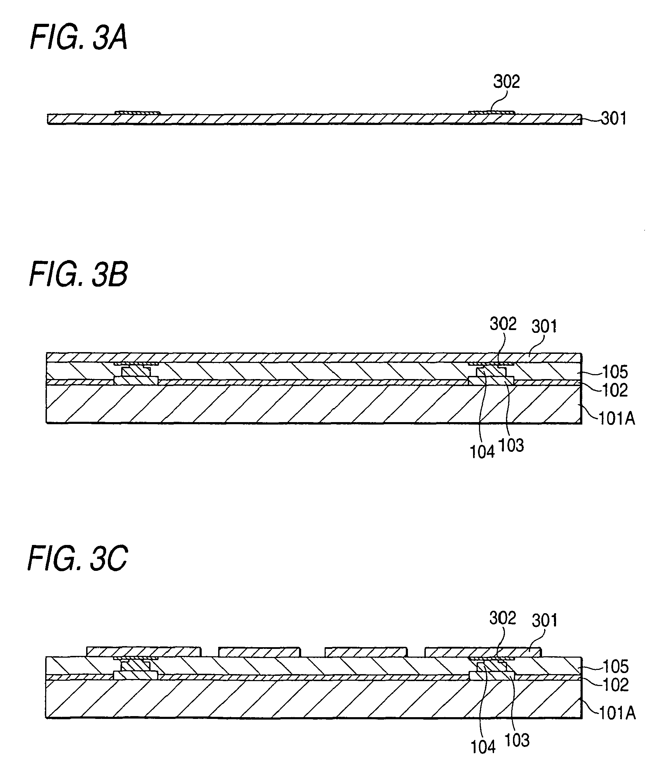

Next, a description is made of an example as to the previously explained second method based upon Fig. 3A to Fig. 3G in a sequential manner.

Firstly, in a step shown in Fig. 3A, a connection pattern 302 made of paste having a conductive characteristic on a conductive layer 301 made of, for instance, Cu by way of, for example, either a printing method or an ink transferring method. In the case of this embodiment 3, since a portion on which the connection pattern 302 is formed is a flat plane shape, the connection portion made of conductive paste can be easily formed, as compared with the above-described case of the embodiment 1.

Next, in a step shown in Fig. 3B, similar to the step of Fig. 1H of the embodiment 1, the conductive layer 301 is adhered through the insulating layer 105 onto the substrate 101A, and the conductive layer 301 is joined to the bump 104 by the connection pattern 302 (conductive paste).

Further, in the above-described case, any one of the following methods may be employed: In one method the insulating layer 105 is firstly formed on the substrate 101A (protection layer 102) by a coating manner, or a laminating manner, and thereafter, the conductive layer 301 is adhered thereto. In another method, the insulating layer 105 and the conductive layer 301 are previously stacked with each other, and then, the stacked layer/substrate is adhered to the substrate 101A (protection film 102).

In this step, both the conductive layer 301 and the insulating layer 105 are pressed and heated. In this step, the insulating layer 105 having a thermosetting characteristic is cured (hardened), and the connection pattern 302 (conductive paste) is cured.

In this step, the connection pattern 302 (conductive paste) is cured under such a condition that a tip portion (projection portion) of the bump 104 has been inserted in the connection pattern 302. As a consequence, reliability as to the electric connection between the bump 104 and the conductive layer 301 can be hardly influenced by fluctuations in heights of the bumps 104. In other words, an allowable value as to the height fluctuations of the bumps 104 is increased in correspondence with a thickness of the connection pattern 302 (conductive paste).

As a consequence, while the bumps 104 having the relatively large height fluctuations are employed which are formed by employing, for example, bonding wires, the re-wiring lines having the superior connection reliability can be manufactured by an easy method.

Further, in this step, the insulating layer 105 is cured (thermally hardened) by that the insulating layer 105 is pressed and heated in combination with the conductive layer 301. As a result, adhesion between the insulating layer 105 and the conductive layer 301 becomes superior.

Next, in a step shown in Fig. 3C, a patterning process of the conductive layer 301 is carried out by performing a pattern etching process with employment of a photolithography method.

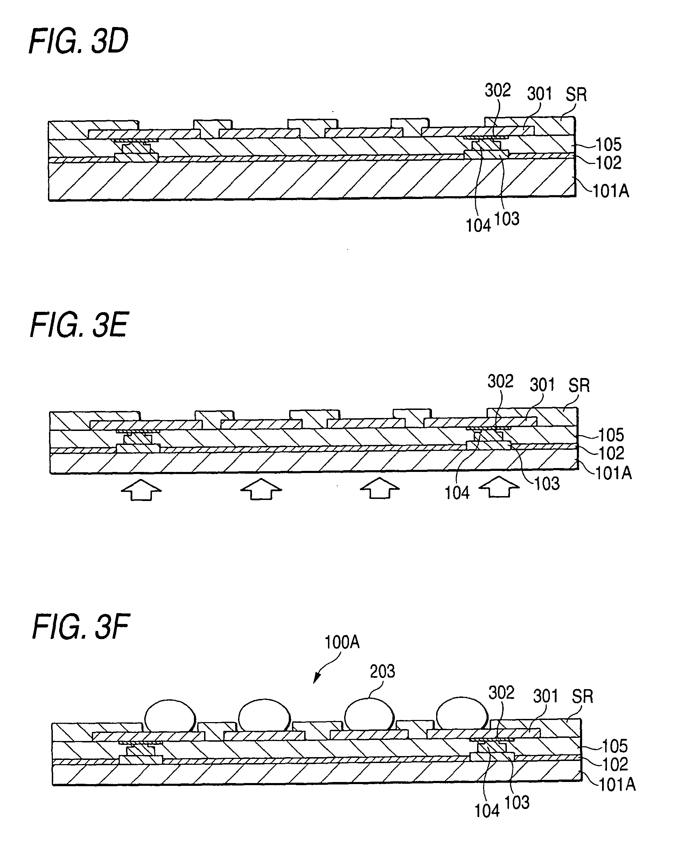

Next, in steps indicated from Fig. 3D to Fig. 3F, process operations similar to those of Fig. 1I to Fig. 1K are performed. Firstly, in a step shown in Fig. 3D, a roughing process (so-called "desmear" process) is carried out with respect to the surface of the conductive layer 301 (Cu), if required, and thereafter, a solder resist layer (insulating layer) SR having an opening portion is formed on the insulating layer 105. Portions of the conductive layer 301 are exposed from the opening portion of the solder resist layer SR.

Next, in a step represented in Fig. 3E, a rear plane of the substrate 101A is polished, if necessary, so as to make a predetermined thickness of the substrate 101A.

Next, in a step indicated in Fig. 3F, solder bumps 203 are formed on the conductive layer 301 which are exposed from the opening portion of the solder resist layer SR, if necessary. In addition, a dicing process of the substrate 101A is carried out in order to cut the substrate 101A in separated pieces, so that the separated substrate piece constitutes a semiconductor chip 101. Thus, a semiconductor device 100 in which the re-wiring line (conductive layer 300) is connected to the semiconductor chip 101 can be manufactured.

The above-described manufacturing method can achieve a similar effect to that of the manufacturing method of the embodiment 1, and can manufacture the semiconductor device having the high reliability in low cost. Further, in the case of this embodiment 3, since the portion on which the connection pattern 302 is formed is the flat plane shape, the connection portion made of the conductive paste can be easily formed, as compared with the case of the embodiment 1. Further, various sorts of methods for forming the connection portion made of the conductive paste can be selected.

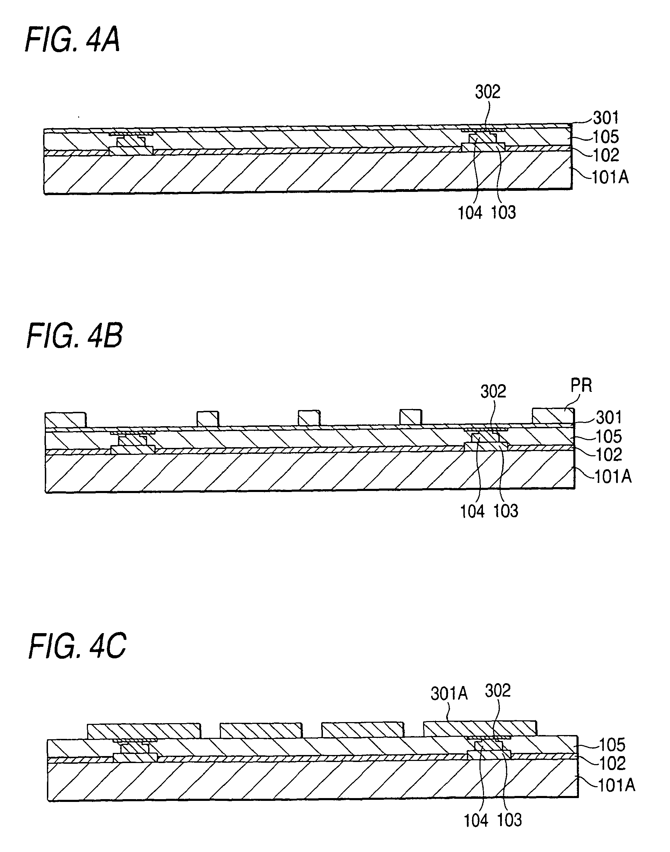

Alternatively, as will be discussed in the following description, the above-described re-wiring line may be formed by employing a semi-additive method. In this alternative case, for instance, in the above-described manufacturing method, the steps shown in Fig. 3A to Fig. 3B are firstly executed so as to form such a condition as indicated in Fig. 4A. It should be noted that in the case of this embodiment 4, it is preferable to make the thickness of the conductive layer 301 thinner than that of the above-described embodiment 3, since the conductive layer 301 corresponds to a seed layer (power feeding layer) and is removed in the later step.

Next, in a step shown in Fig. 4B, a mask pattern PR having an opening portion if formed. The mask pattern PR can be formed by forming a resist layer by being coated, or by adhering a film, and also, by patterning the formed resist layer with employment of a photolithography method.

Next, in a step shown in Fig. 4C, a conductive layer (conductive pattern) 301C made of Cu is formed on the conductive layer 301 exposed from the opening portion of the mask pattern PR by such an electrolytic plating that the conductive layer 301 is employed as a power feeding layer (seed layer). After the above-described pattern plating has been carried out, since the mask pattern PR is stripped and the mask pattern PR is furthermore stripped, extra conductive layer 301 which is exposed is removed by an etching process, so that a similar structure to that of Fig. 3C can be manufactured. Subsequently, since steps similar to the above-described steps indicated in Fig. 3D to Fig. 3F are carried out, a semiconductor device can be manufactured.

Further, as will be represented below, the conductive layer 301 according to the embodiment 4 may be alternatively adhered onto the substrate 101A (insulating layer 105) under such a condition that the conductive layer 301 is supported (stacked layer) by a supporting layer (carrier layer) which supports the conductive layer 301.

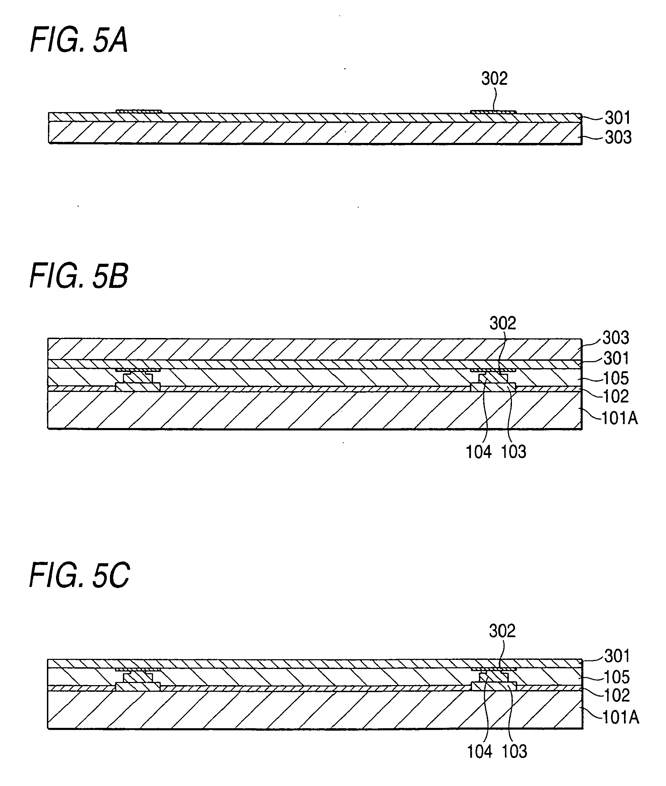

Fig. 5A to Fig. 5C are diagrams for indicating a manufacturing method of a semiconductor device according to an embodiment 5. Firstly, in a step shown in Fig. 5A, a connection pattern 302 made of conductive paste is formed on the conductive layer 301 made of Cu and formed on the supporting layer (carrierlayer) 303 made of, for example, Cu in a similar manner to that of the embodiment 3 shown in Fig. 3A.

Next, in a step shown in Fig. 5B, the conductive layer 301 supported (stacked layer) on the supporting layer 303 is adhered through the insulating layer 105 on the substrate 101A, and the conductive layer 301 is joined to the bump 104 by the connection pattern 302 (conductive paste).

Further, in the above-described case, any one of the following methods may be employed: In one method the insulating layer 105 is firstly formed on the substrate 101A (protection layer 102) by a coating manner, or a laminating manner, and thereafter, the conductive layer 301 supported by the supporting layer 303 is adhered thereto. In another method, the insulating layer 105 and the conductive layer 301 supported by the supporting layer 303 are previously stacked with each other, and then, the stacked layer/substrate is adhered to the substrate 101A (protection film 102).

Next, in a step of Fig. 5C, the supporting layer 303 which has supported the conductive layer 301 is removed. Subsequently, similar to the above-described case of the embodiment 3 (Fig. 3B), both the conductive layer 301 and the insulating layer 105 are pressed and heated. In this step, the insulating layer 105 having the thermosetting characteristic is cured (hardened), and the connection pattern 302 (conductive paste) is cured.

Subsequent to the above-described step of Fig. 5C, the steps shown in Fig. 3C to Fig. 3F of the embodiment 3 are carried out, so that a semiconductor device can be manufactured.

In this embodiment 5, since the conductive layer 301 is adhered onto the substrate 101A (insulating layer 105) under such a condition that the conductive layer 301 has been supported by the supporting layer 303, even when the thickness of the conductive layer 301 is thin, the conductive layer 301 can be adhered onto the substrate 101A under stable condition.

Further, in the case that a re-wiring line is formed, as shown in the below-mentioned drawings, a stacked layer-purpose substrate (core substrate) may be alternatively adhered onto the substrate 101A (insulating layer 105) so as to form the re-wiring line.

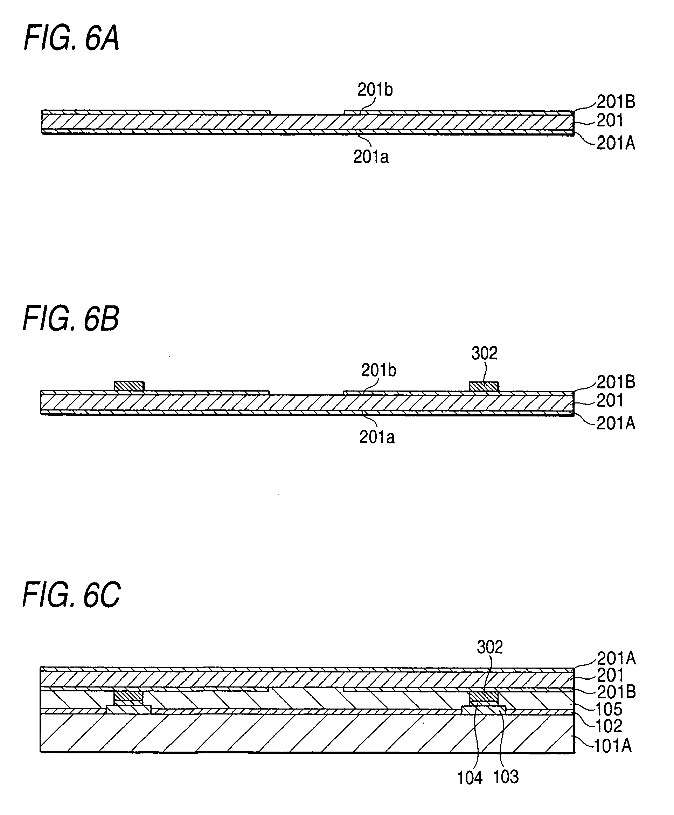

Fig. 6A to Fig. 6H are diagrams for representing a manufacturing method of a semiconductor device according to an embodiment 6. Firstly, similar to the above-described case shown in Fig. 1D of the embodiment 1, in a step shown in Fig. 6A, a stacked layer-purpose substrate (core substrate) 201 is prepared, the stacked layer-purpose substrate 201 is made of such a resin material as a prepreg material, and is equipped with Cu foil on both planes thereof. Conductive layers 201A and 201B made of Cu foil have been adhered onto a first major plane 201a and a second major plane 201b of the stacked layer-purpose substrate 201.

Next, in a step shown in Fig. 6B, the conductive layer 201B is patterned by performing a pattern etching process with respect to the conductive layer 201B of the second major plane 201b. Moreover, a connection pattern 302 made of conductive paste is formed on the conductive layer 201B after the patterning process by performing, for instance, either a printing method or an ink transferring method.

Next, in a step shown in Fig. 6C, the stacked layer-purpose substrate 201 is adhered through the insulating layer 105 onto the substrate 101A, and then, the conductive layer 201B is joined to the bump 104 by the connection pattern (conductive paste) 302.

Further, in the above-described case, any one of the following methods may be employed: In one method, the insulating layer 105 is firstly formed on the substrate 101A (protection layer 102) by a coating manner, or a laminating manner, and thereafter, the stacked layer-purpose substrate 201 is adhered thereto. In another method, the insulating layer 105 and the stacked layer-purpose substrate 201 are previously stacked with each other, and then, the stacked layer/substrate is adhered to the substrate 101A (protection film 102).

In this step, both the stacked layer-purpose substrate 201 and the insulating layer 105 are pressed and heated. In this step, the insulating layer 105 having a thermosetting characteristic is cured, and the connection pattern (conductive paste) 302 is cured.

Similar to the cases of the embodiment 3 to the embodiment 5, in this step, reliability as to the electric connection between the bump 104 and the conductive layer 201B can be hardly influenced by fluctuations in heights of the bumps 104. In other words, an allowable value as to the height fluctuations of the bumps 104 is increased in correspondence with a thickness of the connection pattern 302 (conductive paste).

Further, in this step, the insulating layer 105 is cured (thermally hardened) by that the insulating layer 105 is pressed and heated in combination with the conductive layer 201B. As a result, adhesion between the insulating layer 105 and the conductive layer 201B becomes superior.

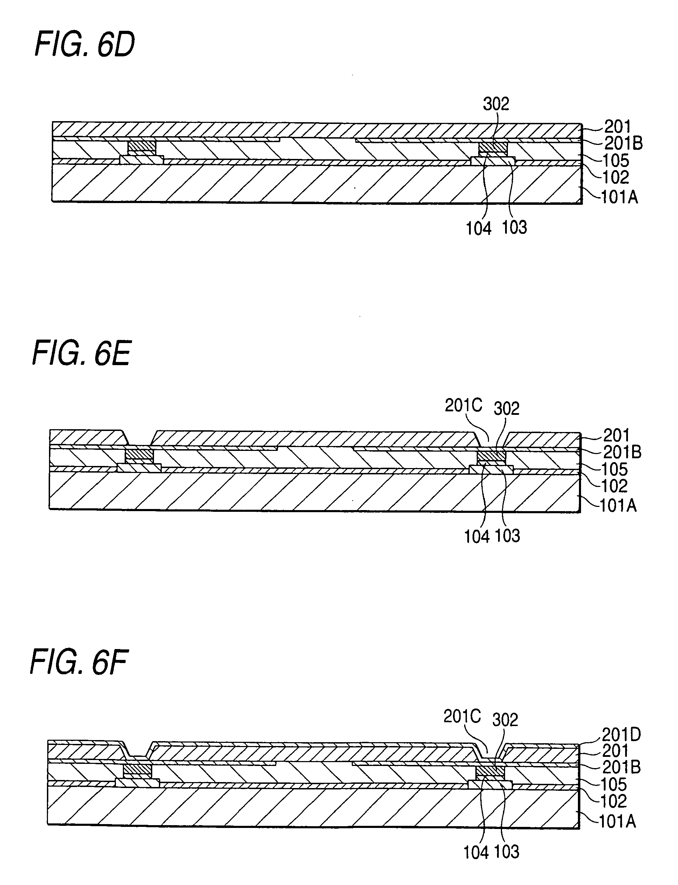

Next, in a step shown in Fig. 6D, the conductive layer 201A of the stacked layer-purpose substrate 201 is removed by an etching process operation.

Next, in a step indicated in Fig. 6E, similar to the step of Fig. 1F of the embodiment 1, such a via hole 201C which penetrates through the stacked layer-purpose substrate 201 and then reaches the conductive layer 201B is formed by employing, for example, a laser, or the like.

Next, in a step shown in Fig. 6F, after a desmear process has been carried out, if necessary, a conductive layer (power feeding layer) 201D made of Cu is formed on a surface of the stacked layer-purpose substrate 201, which contains an inner wall plane of the via hole 201C by employing, for example, an electroless platingmethod.

In steps subsequent to this step of Fig. 6F, conductive patterns (via plug and pattern wiring line) may be manufactured by employing, for example, either a subtractive method or a semi-additive method. A first description is made of such a case that the subtractive method is employed.

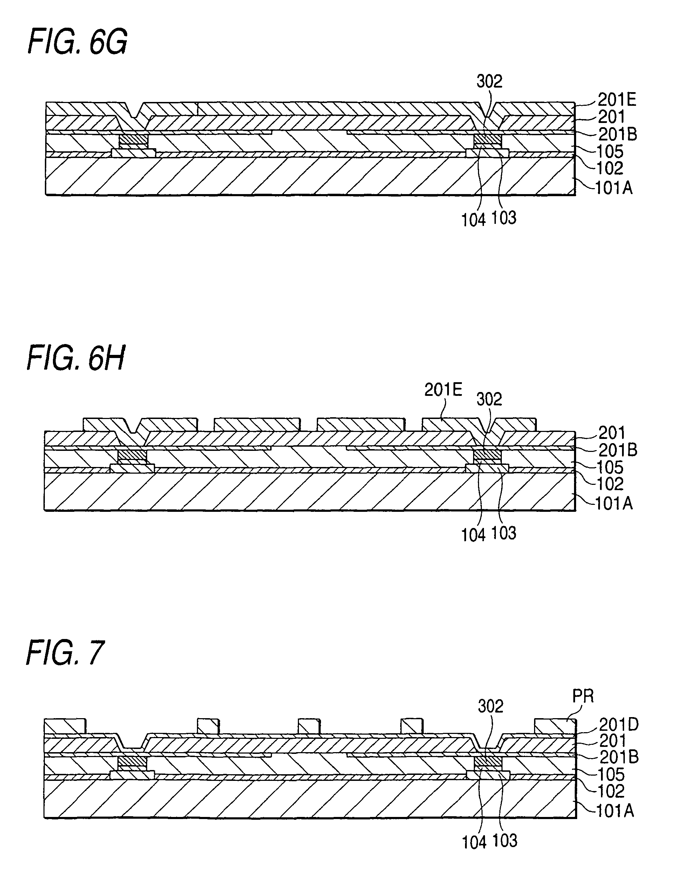

Next, in a step indicated in Fig. 6G, a conductive layer 201E is formed on the conductive layer 201D by performing an electrolytic plating method while the conductive layer 201D is employed as a power feeding layer (seed layer).

Next, in a step shown in Fig. 6H, since the conductive layer 201E is pattern-etched, both a via plug which penetrates through the stacked layer-purpose substrate 201, and a pattern wiring line which is connected to the via plug can be formed. Thereafter, steps similar to the steps shown in Fig. 3E to Fig. 3G of the embodiment 3 are performed, so that a semiconductor device can be manufactured.

Further, in this embodiment 6, when a wiring line is formed by the semi-additive method, a step of Fig. 7 may be performed after the above-explained step of Fig. 6F. In the step of Fig. 7, a mask pattern having an opening portion is formed on the conductive layer 201D.

Next, a conductive layer made of Cu is formed on the conductive layer 201A exposed from the opening portion of the mask pattern PR by such an electrolytic plating that the conductive layer 201A is employed as a power feeding layer. After the above-described pattern plating has been carried out, since the mask pattern PR is stripped and the mask pattern PR is furthermore stripped, an extra conductive layer which is exposed is removed by an etching process, so that a similar structure to that of Fig. 6H can be manufactured.

Alternatively, a previously-formed multilayer wiring line structure may be adhered onto the substrate 101A (semiconductor chip) so as to construct a semiconductor device. Further, as a method for forming the multilayer wiring structure, there are a method for removing a predetermined supporting layer after a multilayer wiring line structure has been formed on this predetermined supporting layer, and another method for forming a multilayer wiring line structure by employing a core substrate. In this embodiment 7, a first description is made of the method for forming.the multilayer wiring line structure on the supporting layer.

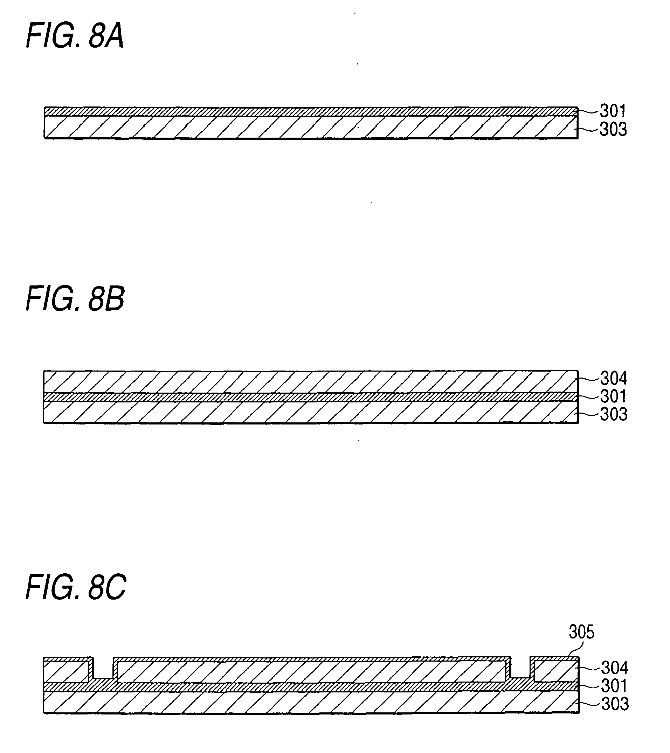

Firstly, in a step indicated in Fig. 8A, similar to the step shown in Fig. 5A of the embodiment 5, for example, such a structure is prepared in which a conductive layer 301 made of Cu has been formed on a supporting layer (carrier layer) 303 made of Cu.

Next, in a step shown in Fig. 8B, an insulating layer 304 made of, for example, a resin material (build up resin) of an epoxy series is formed by adhering a film, or by coating a fluid-shaped resin.

Next, in a step represented in Fig. 8C, a via hole which penetrates through the insulating layer 304 is formed by using, for example, a laser, and a desmear process is carried out with respect to the via hole, if necessary. Thereafter, for instance, a conductive layer (power feeding layer) 305 made of Cu is formed on a surface of the insulating layer 304 containing an inner wall plane of this via hole by employing, for example, an electroless plating method.

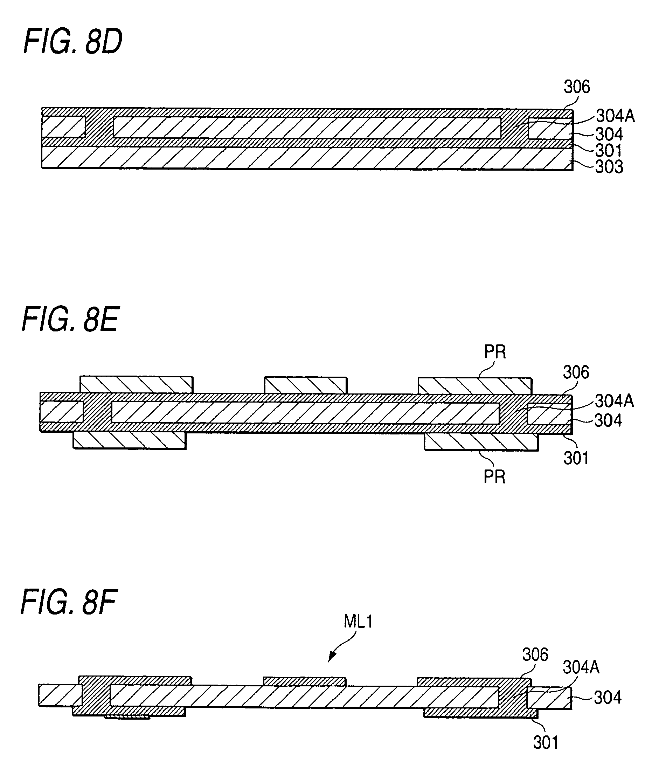

Next, in a step shown in Fig. 8D, a conductive layer 306 is formed on the conductive layer 305 by performing an electrolytic plating method while the conductive layer 305 is employed as a power feeding layer (seed layer). As a result, a via plug 304A which penetrates through the insulating layer 304 is formed, and another conductive layer 306 is formed which is connected to the above-described via plug 304A.

Next, in a step indicated in Fig. 8E, mask patterns PR are formed on the conductive layer 301 and the conductive layer 306 respectively by photoresists. In a step shown in Fig. 8F, a pattern etching process is performed so as to pattern the conductive layers 301 and 306. A multilayer wiring line structure ML1 is formed in the above-described manner, while the multilayer wiring line structure ML1 is constructed by that the conductive layers (wiring line patterns) 301 and 306 formed on both planes of the insulating layer 304 are connected by the via plug 304A.

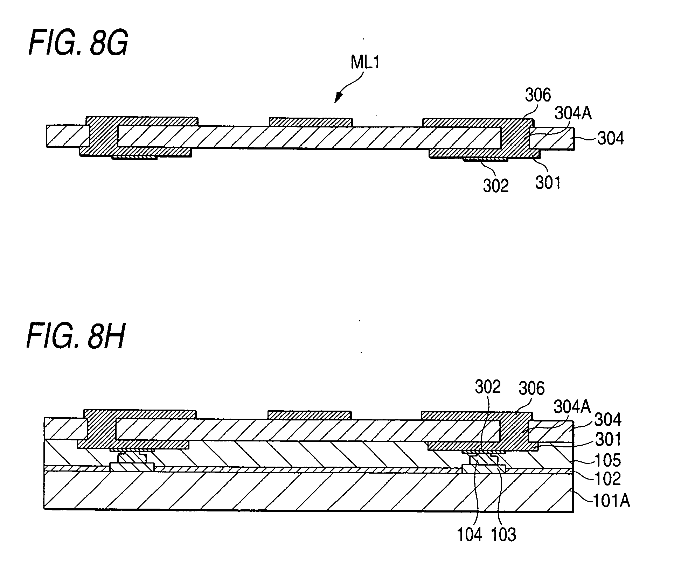

Next, in a step indicated in Fig. 8G, a connection pattern 302 made of conductive paste on the conductive layer 301 by executing, for example, either a printing method or an ink transferring method.

Next, in a step shown in Fig. 8H, the multilayer wiring line structure ML1 is adhered through the insulating layer 105 onto the substrate 101A, and the conductive layer 301 is joined to the bump 104 by the connection pattern 302 (conductive paste).

Further, in the above-described case, any one of the following methods may be employed: In one method, the insulating layer 105 is firstly formed on the substrate 101A (protection layer 102) by a coating manner, or a laminating manner, and thereafter, the multilayer wiring line structure ML1 is adhered thereto. In another method, the multilayer wiring line structure ML1 and the insulating layer 105 are previously stacked on the substrate 101A (on protection layer 102). Further, similar to the case of the embodiment 3 (Fig. 3B), the conductive layer 301 and the insulating layer 105 are pressed and heated. In this step, the insulating layer 105 having a thermosetting characteristic is cured (hardened), and the conductive paste 202 is cured.

In steps subsequent to the above step of Fig. 8G, steps similar to the steps of Fig. 3D to Fig. 3F of the embodiment 3 are carried out, so that a semiconductor device can be manufactured.

As will be described below, such a structure corresponding to the multilayer wiring line structure ML1 of the above-describe embodiment 6 may be alternatively constructed by employing, for instance, a core substrate.

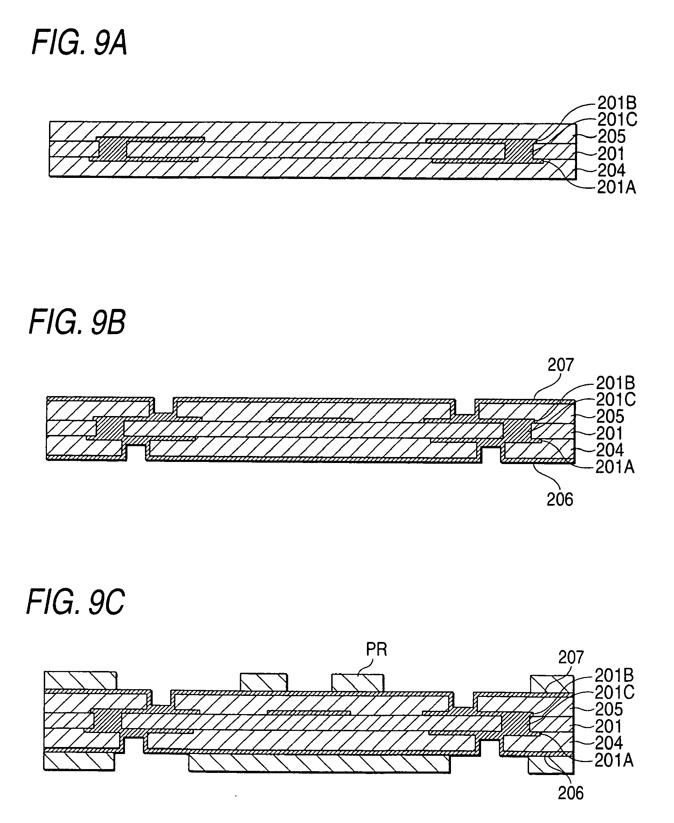

Firstly, in a step shown in Fig. 9A, a stacked layer-purpose substrate (core substrate) 201 having Cu foil (conductive layers 201A and 201B) on both planes thereof is prepared, while the stacked layer-purpose substrate 201 is made of a resin material such as a prepreg material similar to that shown in Fig. 1D of the embodiment 1 . In this step, a via hole (through hole) is formed which penetrates through the stacked layer-purpose substrate 201, and a via hole 201C is formed which embeds the above-described via hole by performing, for instance, a plating method. Furthermore, the conductive layers 201A and 201B are patterned by a pattern etching process so as to form both an insulating layer 204 for covering the conductive layer 201A, and another insulating layer 205 for covering the conductive layer 201B. Further, the insulating layers 204 and 205 are formed by adhering a film made of, for instance, a resin material (build up resin) of an epoxy series, or by coating the above-described fluid-like resin material.

Next, in a step indicated in Fig. 9B, a via hole is formed which penetrates through the insulating layer 204 and then reaches the conductive layer 201A, and a desmear process is carried out with respect to the via hole if required. Thereafter, for instance, a conductive layer (power feeding layer) 206 made of Cu is formed on a surface of the insulating layer 204 containing an inner wall plane of this via hole by employing, for example, an electroless plating method.

Similarly, a via hole is formed which penetrates through the insulating layer 205 and then reaches the conductive layer 201B, and a desmear process is carried out with respect to the via hole if necessary. Thereafter, for instance, a conductive layer (power feeding layer) 207 made of Cu is formed on a surface of the insulating layer 205 containing an inner wall plane of this via hole by employing, for example, an electroless plating method.

Next, in a step indicated in Fig. 9C, mask patterns PR are formed on the conductive layer 206 and the conductive layer 207 respectively by photoresists.

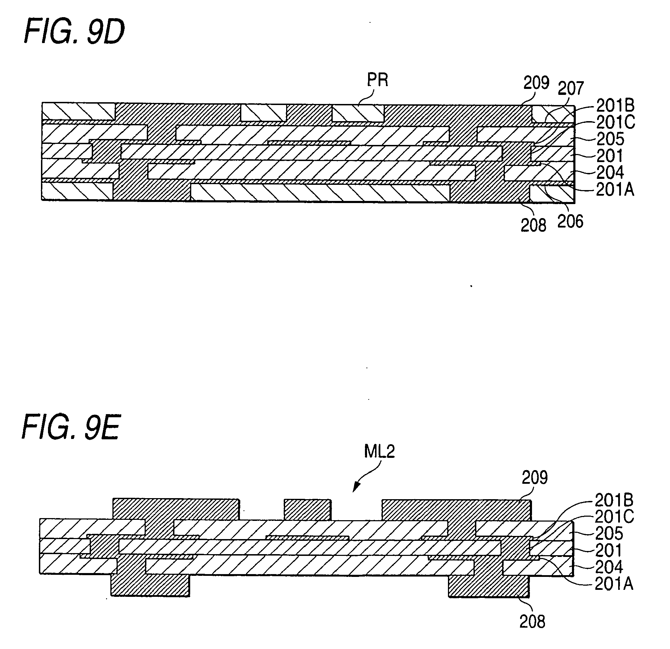

Next, in a step shown in Fig. 9D, a conductive layer (via plug and pattern wiring line) 208 made of Cu is formed on the conductive layer 206 by performing an electrolytic plating method, while the conductive layer 206 is employed as a power feeding layer. Similarly, a conductive layer (via plug and pattern wiring line) 209 made of Cu is formed on the conductive layer 207 by performing an electrolytic plating method, while the conductive layer 207 is employed as a power feeding layer.

Next, in a step represented in Fig. 9E, the mask patterns PR are stripped, and further, the power feeding layer is removed which is exposed by stripping the mask patterns PR, so that a multilayer wiring line structure ML2 can be formed.

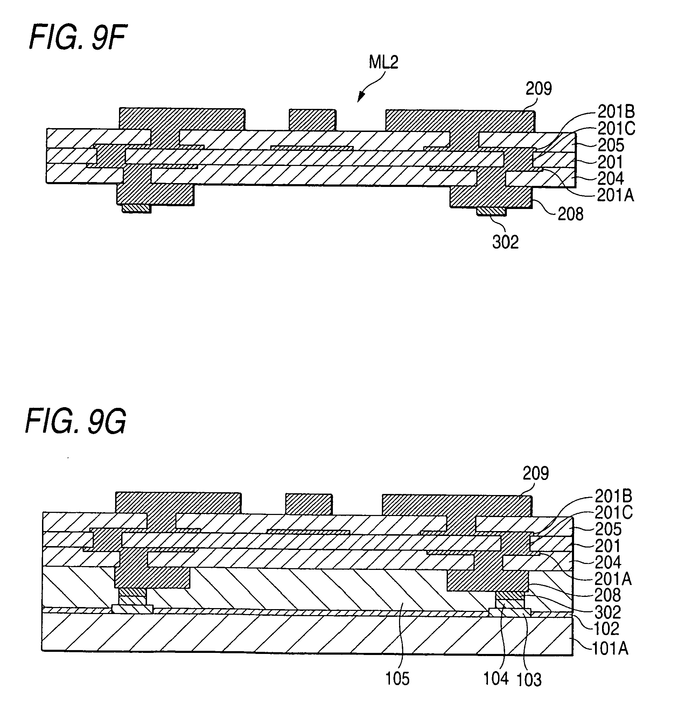

Next, in a step indicated in Fig. 9F, a connection pattern 302 made of conductive paste on the conductive layer 208 by executing, for example, either a printing method or an ink transferring method.

Next, in a step shown in Fig. 9G, the multilayer wiring line structure ML2 is adhered through the insulating layer 105 onto the substrate 101A, and the conductive layer 208 is joined to the bump 104 by the connection pattern 302 (conductive paste).

Further, in the above-described case, any one of the following methods may be employed: In one method, the insulating layer 105 is firstly formed on the substrate 101A (protection layer 102) by a coating manner, or a laminating manner, and thereafter, the multilayer wiring line structure ML2 is adhered thereto. In another method, the multilayer wiring line structure ML2 and the insulating layer 105 are previously stacked on the substrate 101A (on protection layer 102). Further, similar to the case of the embodiment 3 (Fig. 3B), the conductive layer 301 and the insulating layer 105 are pressed and heated. In this step, the insulating layer 105 having a thermosetting characteristic is cured, and the connection pattern 302 (conductive paste) is cured.

In steps subsequent to the above step of Fig. 9G, steps similar to the steps of Fig. 3D to Fig. 3F of the embodiment 3 are carried out, so that a semiconductor device can be manufactured.

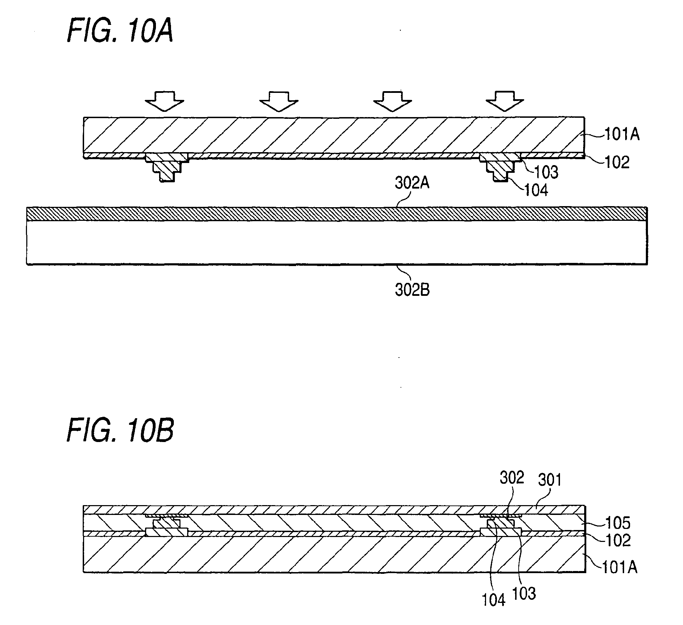

Next, a description is made of one example as to the previously described third method based upon Fig. 10A to Fig. 10B in a sequential manner. The above-described third method is featured by that a connection pattern (conductive paste) used to join a bump to a conductive layer is not formed on either a substrate or the conductive layer, but is formed on the side of the bump.

Firstly, in a step shown in Fig. 10A, a tip portion of the bump 104 formed on the electrode pad 103 of the substrate 101A is contacted to a transferring layer 302A made of conductive paste set on, for example, a squeezing apparatus 302 so as to transfer the conductive paste to the tip portion of the bump 104.

Next, in a step shown in Fig. 10B, the conductive layer 301 is adhered through the insulating layer 105 onto the substrate 101A, and then, the conductive layer 301 is joined to the bump 104 by the connection pattern 302 (conductive paste) transferred to the tip portion of the bump 104.

In this step, both the conductive layer 301 and the insulating layer 105 are pressed and heated. In this case, the insulating layer 105 having the thermosetting characteristic is cured, and the connection pattern 302 (conductive paste) is cured.

In steps subsequent to the above step of Fig. 10A, steps similar to the steps of Fig. 3D to Fig. 3F of the embodiment 3 are carried out, so that a semiconductor device can be manufactured.

In the case of this embodiment 9, a dispenser, or a printing apparatus which coats, or prints the conductive layer are not required. As a result, there is such a merit that the method for manufacturing the semiconductor device can be simplified, and the manufacturing cost of the semiconductor device can be reduced. As previously described, the conductive paste for joining the conductive layer to the bump may be coated not only the conductive layer side, but also the bump side (printing and coating etc.).

While the present invention has been described with reference to the preferred embodiments, the present invention is not limited only to the above-described specific embodiments, but may be modified and changed in various manners within the gist described in the scope of claims.

In accordance with the present invention, it is possible to provide the manufacturing method of the semiconductor device, by which the highly reliable semiconductor device can be manufactured in low cost.

## Claims

1. A manufacturing method of a semiconductor device, comprising:
a step for forming a bump (104) on an electrode pad (103) by a bonding wire, the electrode pad being formed in an area corresponding to a semiconductor chip of a substrate (101A);
a step for forming a via hole (201C) in a stacked layer-purpose substrate (201) stacked on the substrate, a conductive layer (201A) being formed on a first major plane of the stacked layer-purpose substrate, the via hole reaching from a second major plane of the stacked layer-purpose substrate to the conductive layer, and for embedding the via hole by conductive paste (202);
a step for adhering the stacked layer-purpose substrate through an insulating layer (105) onto the substrate, and for joining the conductive layer to the bump by the conductive paste; and
a step for dividing the substrate in separated pieces, wherein
the bump penetrates the insulating layer.

2. The manufacturing method of a semiconductor device as claimed in claim 1, further comprising:
a step for etching the conductive layer so as to pattern the conductive layer.

3. The manufacturing method of a semiconductor device as claimed in any of claims 1 to 2, further comprising:
a step for performing a pattern plating process by an electrolytic plating process, the conductive layer (201A) being employed as a power feeding layer.

4. A manufacturing method of a semiconductor device, comprising:
a step for forming a bump (104) on an electrode pad (103) by a bonding wire, the electrode pad being formed in an area corresponding to a semiconductor chip of a substrate;
a step for forming a connection pattern (302)made of conductive paste on a conductive layer (201b; 301) which is stacked on the substrate;
a step for adhering the conductive layer through an insulating layer (105) onto the substrate, and for joining the conductive layer to the bump by the connection pattern; and
a step for dividing the substrate in separated pieces, wherein
the bump penetrates the insulating layer.

5. The manufacturing method of a semiconductor device as claimed in claim 4, further comprising:
a step for etching the conductive layer (201b; 301) so as to pattern the conductive layer.

6. The manufacturing method of a semiconductor device as claimed in any of claims 4 to 5, further comprising:
a step for performing a pattern plating process by an electrolytic plating process, the conductive layer (201b; 301) being employed as a power feeding layer.

7. The manufacturing method of a semiconductor device as claimed in any of claims 4 to 6, wherein
the conductive layer (301) is stackedon a supporting layer (302) for supporting the conductive layer and is adhered through the insulating layer onto the substrate, and
after the conductive layer is adhered onto the substrate, the supporting layer is removed.

8. The manufacturing method of a semiconductor device as claimed in any of claims 4 to 7, wherein
the conductive layer to be stacked on the substrate is a conductive layer which constitutes a multilayer wiring line structure (ML1; ML2).

9. A manufacturing method of a semiconductor device, comprising:
a step for forming a bump (104) on an electrode pad (103) by a bonding wire, the electrode pad being formed in an area corresponding to a semiconductor chip of a substrate (101A);
a step for contacting a tip portion of the bump to a layer made of conductive paste so as to transfer the conductive paste to the tip portion;
a step for adhering a conductive layer stacked on the substrate through an insulating layer onto the substrate, and for joining the conductive layer to the bump by the conductive paste; and
a step for dividing the substrate in separated pieces, wherein
the bump penetrates the insulating layer.
